# EUROPÄISCHE PATENTANMELDUNG

(11) **EP 1 406 387 A1**
(43) Veröffentlichungstag der Anmeldung: **07.04.2004**
(21) Anmeldenummer: 03021976.0
(22) Anmeldetag: 30.09.2003
(51) Int. Cl.: H03K 17/96

(54) **Bedieneinrichtung für ein Gargerät**

(30) Priorität: 04.10.2002 DE 20215326 U
(71) Anmelder: Diehl AKO Stiftung & Co. KG, 88239 Wangen (DE)
(72) Erfinder: Hammelsbacher, Karlheinz, 91189 Rohr (DE); Ennen, Peter, 90584 Allersberg (DE)
(74) Vertreter: Diehl Patentabteilung

(57) **Zusammenfassung**

Es wird eine Bedienungseinrichtung für ein Gargerät mit einem berührungsempfindlichen Tastschalter und mit einer sichtbares Licht ausstrahlenden Signalisierungsleuchte 2 vorgeschlagen, wobei der Tastschalter einen elektromagnetische Strahlung aussendenden Sender 3 und einen elektromagnetische Strahlung empfangenden Empfänger 4 aufweist, welche innerhalb eines Blendenrahmens 5 angeordnet sind, und wobei auch die Signalisierungsleuchte 2 innerhalb des Blendenrahmens 5 angeordnet ist.

## Beschreibung

Die Erfindung betrifft eine Bedienungseinrichtung für ein Gargerät nach dem Oberbegriff des Schutzanspruchs 1.

Solche bekannte Bedienungseinrichtungen weisen Tastschalter auf, die aus einem Infrarot-Sender und einem Infrarot-Empfänger bestehen. Bei einer Bedienung der Tastschalter z. B. mit einem Finger wird die vom Sender ausgehende Infrarot-Strahlung reflektiert und von dem Empfänger detektiert. Daneben ist noch eine im sichtbaren Spektrum strahlende Leuchte angeordnet, welche dem Benutzer eine erfolgte Betätigung oder eine mögliche Betätigbarkeit des Tastschalters signalisiert.

Während der Infrarot-Sender und der Infrarot-Empfänger von einem Blendenrahmen umgeben sind, um Streulichteinflüsse zu verhindern, sitzt die Signalisierungsleuchte nicht in einem solchen Blendenrahmen. Dies führt dazu, dass das Licht dieser Leuchte dem Benutzer diffus strahlend erscheint.

Somit liegt die Aufgabe der Erfindung darin, eine gattungsgemäße Bedienungseinrichtung vorzuschlagen, bei welcher das Signalisierungslicht eng begrenzt strahlt.

Diese Aufgabe wird durch eine Bedienungseinrichtung mit den Merkmalen des Schutzanspruchs 1 gelöst. Vorteilhafte Ausgestaltungen und Weiterbildungen der Erfindung sind in den abhängigen Ansprüchen erläutert.

Durch die Integrierung der Signalisierungsleuchte innerhalb des Blendenrahmens wird erreicht, dass deren Licht nicht diffus ausstrahlt, sondern definiert in Richtung des Benutzers gerichtet wird.

In vorteilhafter Ausgestaltung ist vorgesehen, dass die Signalisierungsleuchte und der Sender innerhalb eines ersten Blendenrahmens und der Empfänger innerhalb eines zweiten Blendenrahmens angeordnet sind, wobei der erste und der zweite Blendenrahmen auch aneinanderstoßend oder gar einstückig ausgeformt sein können.

Signalisierungsleuchte und Sender können durch eine einzige Leuchtdiode gebildet sein, welche bevorzugt sowohl im sichtbaren als auch zumindest im nahen Infrarot-Bereich leuchtet. Alternativ können Signalisierungsleuchte und Sender durch zwei Leuchtdioden gebildet sein, die vorzugsweise auf einem gemeinsamen Chip angeordnet und verschaltet sind.

Weiterhin kann vorgesehen sein, dass im Strahlengang vor dem Empfänger ein optischer Filter angeordnet ist.

Üblicherweise ist eine solche Bedienungseinrichtung unterhalb einer Glaskeramikplatte einer Kochmulde eines Küchenherdes angeordnet.

Anhand der Zeichnung soll im folgenden die Erfindung näher erläutert werden. Es zeigen:
- Figur 1: einen Tastschalter und eine Signalisierungsleuchte einer Bedienungseinrichtung nach dem Stand der Technik in perspektivischer Darstellung,
- Figur 2: einen Tastschalter mit Signalisierungsleuchte nach einem ersten Ausführungsbeispiel in Aufsicht und
- Figur 3: einen Tastschalter mit Signalisierungsleuchte nach einem zweiten Ausführungsbeispiel, ebenfalls in Aufsicht.

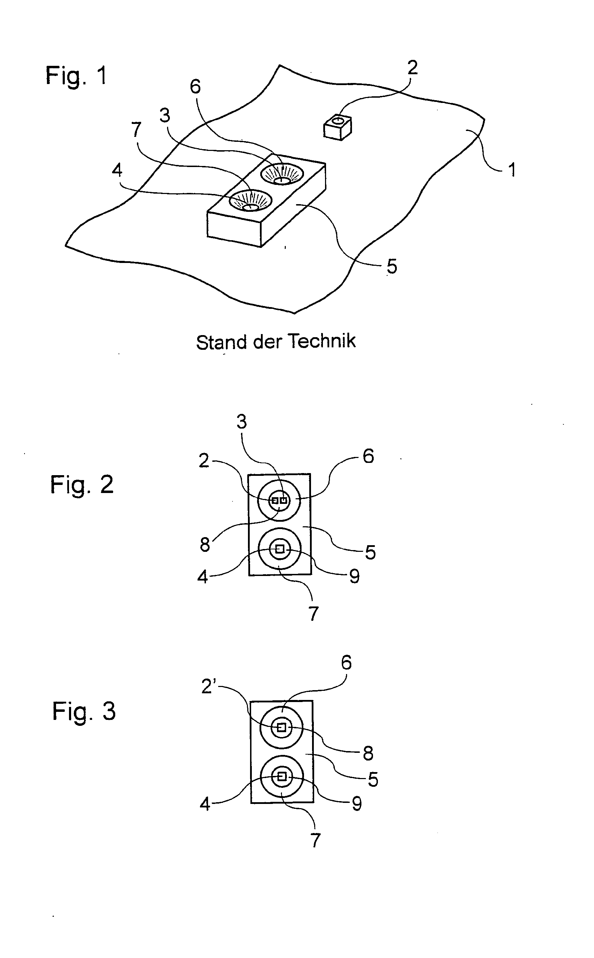

In einer Bedienungseinrichtung nach dem Stand der Technik sind gemäß Figur 1 auf einer Leiterplatte 1 eine rot strahlende Leuchtdiode 2, eine Infrarot-Leuchtdiode 3 sowie ein Fototransistor 4 angeordnet und verschaltet. Die Infrarot-Leuchtdiode 3 und der Fototransistor 4 sind von einem Blendenrahmen 5 derart umgeben, dass sie jeweils in getrennten Ausnehmungen 6 und 7 in dem Körper des Blendenrahmens 5 angeordnet sind.

Die rote Leuchtdiode 2 zeigt die Betätigbarkeit oder auch eine Betätigung des Tastschalters an, während der Fototransistor 4 das von der Infrarot-Leuchtdiode 3 ausgesandte und bei einer Betätigung des Tastschalter z. B. mit einem Finger zurückreflektierte Infrarotlicht detektiert.

Gemäß einem ersten Ausführungsbeispiel der Erfindung (siehe Figur 2) sind sowohl die Infrarot-Leuchtdiode 3 als auch die rot leuchtende Leuchtdiode 2 innerhalb der ersten Ausnehmung 6 des Blendenrahmens 5 angeordnet. Die beiden Leuchtdioden 2 und 3 sind dabei überdies auf einem einzigen Chip 8 befestigt. Der Fototransistor 4 befindet sich auf einem eigenen Chip 9 in der zweiten Ausnehmung 7 des Blendenrahmens 5.

Im Betrieb des Tastschalters kann vorgesehen sein, dass die Infrarot-Leuchtdiode 3 und die rote Leuchtdiode 2 nur abwechselnd in Betrieb sind, um eine Auswertung des Signals des Fototransistors 4 zu erleichtern.

Gemäß einem zweiten Ausführungsbeispiel der Erfindung (siehe Figur 3) befindet sich auf dem ersten Chip 8 in der ersten Ausnehmung 6 des Blendenrahmens 5 nur eine Leuchtdiode 2', welches sichtbares (z. B. rotes) Licht ausstrahlt. Diese Leuchtdiode 2' dient nunmehr sowohl als Signalisierungsleuchte als auch als Sender für den Tastschalter. Der Betrieb der Leuchtdiode 2' kann durchgehend, gepulst oder auch moduliert erfolgen. Dabei kann vorgesehen sein, dass der Fototransistor 4 nur den Infrarot-Anteil des von der Leuchtdiode 2' ausgesandten Lichts oder aber auch den sichtbaren Anteil zur Erkennung eines Tastendrucks verwertet.

Bei beiden Ausführungsformen kann vorgesehen sein, dass über dem Fototransistor 4 ein optischer Filter angeordnet ist, welcher nur bestimmte Spektralbereiche des Lichts (z. B. nahes Infrarot) durchlässt.

## Patentansprüche

1. Bedienungseinrichtung für ein Gargerät mit mindestens einem berührungsempfindlichen Tastschalter, welcher einen elektromagnetische Strahlung aussendenden Sender (3) und einen elektromagnetische Strahlung empfangenden Empfänger (4) aufweist, welche innerhalb eines Blendenrahmens (5) angeordnet sind, und mit einer sichtbares Licht ausstrahlenden Signalisierungsleuchte (2),
**dadurch gekennzeichnet,**
**dass** auch die Signalisierungsleuchte (2) innerhalb des Blendenrahmens (5) angeordnet ist.

2. Bedienungseinrichtung nach Anspruch 1,
**dadurch gekennzeichnet,**
**dass** die Signalisierungsleuchte (2) zusammen mit dem Sender (3) innerhalb eines ersten Blendenrahmens (5, 6) und der Empfänger (4) innerhalb eines zweiten Blendenrahmens (5, 7) angeordnet ist.

3. Bedienungseinrichtung nach Anspruch 2,
**dadurch gekennzeichnet,**
**dass** der erste und der zweite Blendenrahmen (5 bis 7) aneinanderstoßend oder einstückig ausgeformt sind.

4. Bedienungseinrichtung nach einem der Ansprüche 1 bis 3,
**dadurch gekennzeichnet,**
**dass** die Signalisierungsleuchte (2) und der Sender (3) durch eine einzige Leuchtdiode (2') gebildet sind.

5. Bedienungseinrichtung nach Anspruch 4,
**dadurch gekennzeichnet,**
**dass** die Leuchtdiode (2') sowohl im sichtbaren als auch im zumindest nahen Infrarot-Bereich leuchtet.

6. Bedienungseinrichtung nach einem der Ansprüche 1 bis 3,
**dadurch gekennzeichnet,**
**dass** die Signalisierungsleuchte (2) und der Sender (3) durch zwei Leuchtdioden gebildet sind, welche vorzugsweise auf einem gemeinsamen Chip (8) angeordnet und verschaltet sind.

7. Bedienungseinrichtung nach einem der vorherigen Ansprüche,
**dadurch gekennzeichnet,**
**dass** vor dem Empfänger (4) ein optischer Filter angeordnet ist.

8. Bedienungseinrichtung nach einem der vorherigen Ansprüche,
**dadurch gekennzeichnet,**
**dass** sie unterhalb einer Glaskeramikplatte einer Kochmulde eines Küchenherdes angeordnet ist.
